# EUROPEAN PATENT APPLICATION

(11) **EP 0 965 850 A1**
(43) Date of publication of application: **22.12.1999**
(21) Application number: 98304773.9
(22) Date of filing: 17.06.1998
(51) Int. Cl.: G01R 31/3185

(54) **Scan test method for multiple clocks integrated circuit**

(71) Applicant: LUCENT TECHNOLOGIES INC., Murray Hill, New Jersey 07974-0636 (US)
(72) Inventor: Knaeblein, Joachim, 90489 Nürnberg (DE); Schmid, Josef, 92318 Neumarkt (DE)
(74) Representative: Funnell, Samantha Jane

(57) **Abstract**

The present invention relates generally to the field of integrated circuits and particularly to an integrated circuit and a method for testing integrated circuits.

Integrated circuits having a high integration rate like Very or Ultra Large Scale Integration and being used for complex Application Specific Integrated Circuits and Systems on a Chip require in many cases a multi clock design style for functional and/or performance reasons. Supporting multi clock design very often the problem occurs that testing the integrated circuit becomes very complicated.

The present invention allows simple testing by providing an integrated circuit and a method for testing integrated circuitry having multiple clock systems, including a step of inserting multiplexed scan flip-flops into the circuitry, and further including steps of analysing the circuitry to identify transitions between clock systems, and inserting additional storage elements into the circuitry at locations having transitions between the clock systems.

## Description

### TECHNICAL FIELD

The present invention relates generally to the field of integrated circuits and particularly to an integrated circuit and a method for testing integrated circuits.

### BACKGROUND OF THE INVENTION

Integrated circuits (ICs) having a high integration rate, like Very or Ultra Large Scale Integration (VLSI or ULSI), which are used for complex Application Specific Integrated Circuits (ASICs) and Systems on a Chip (SOCs) require in many cases a multi clock design style for functional and/or performance reasons. Especially in telecommunication applications many complex clock structures are often present and clock domain transitions occur. The reasons for this are the functional and performance requirements, i.e. handling of multiple data channels, datapaths, micro controller interfaces and power management. These requirements complicate the generation of structured test programs based on scan testing with current methods. As a result the test vectors needed for testing these ICs become very complicated, leading to long tester or CPU times for pattern generation, simulation and also long test times at the automatic test equipment. Generating skew insensitive test programs and to verify such programs requires considerable effort.

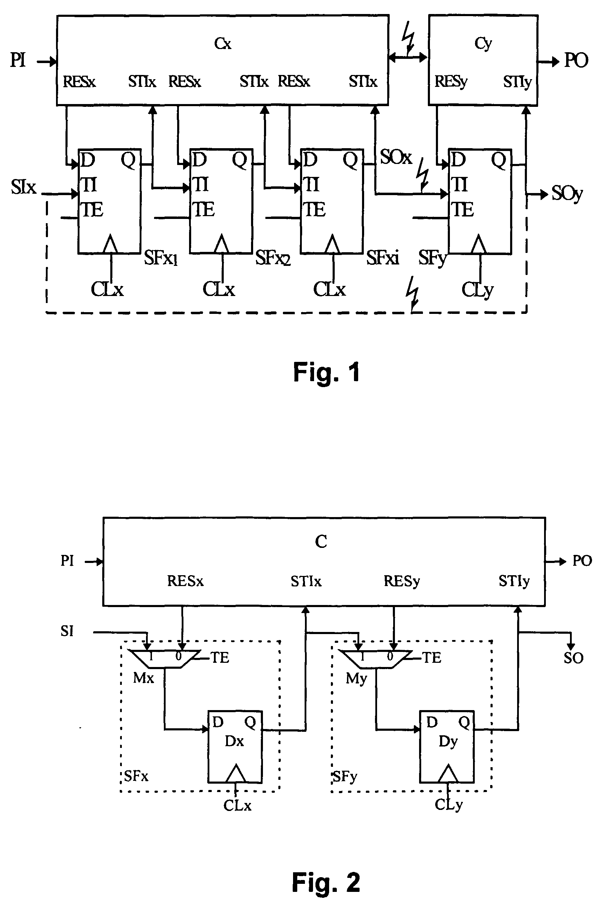

Fig.1 illustrates the basic problem of clock domain transitions. It shows a sequential logic circuit Cx, Cy having inputs PI and outputs PO. Multiplexed scan flip-flops SFx, SFy are used to form scan chains in the x and y clock domains by coupling outputs Q with inputs TI as depicted. There may also be a coupling of output Q of a flip-flop SFx to input TI of flip-flop SFy. The scan flip-fops SFx, SFy are coupled to the logic circuit Cx, Cy. Results RESx, RESy of the logic circuit Cx, Cy are fed to data inputs D of the scan flip-flops SFx, SFy. Outputs Q of the scan flip-flops SFx, SFy are fed to stimuli inputs STIx, STIy of the logic circuit Cx, Cy. A coupling between Cx and Cy may exist as depicted. The scan chain has inputs SIx and outputs SOy. The system is clocked by different clocks CLx, CLy, which are coupled to clock inputs of the flip-flops SFx, SFy. The dashed line indicates that there also may be a coupling between the input SIx and the output SOy of the scan chain. Inputs TE of the scan flip-flops SFx, SFy are used to set the scan chain to a shift mode.

As long as the clocks CLx and CLy are equal and thus having no skew an Automatic Test Pattern Generator (ATPG) as known from the state of the art can generate test patterns for the combinational logic Cx and Cy, respectively. It is shifted into the scan chain (shiftmode TE=1). The result (response) is captured (normal mode, TE=0) into the flip-flops SFx, SFy and shifted out the scan chain (TE=1). If the clocks CLx, CLy are different and there is a transition from the x to the y clock domain there may be a problem at two different paths of the flip-flops SFx, SFy at the scan chain SIx, SOy, SOx causing a scan chain transition and at the response path RESx, RESy caused by a functional transition between Cx and Cy.

Problems may arise at the positions denoted by the flashes in Fig. 1. If the data transition directions at these positions are the same, e.g. from x to y or vice versa, an easy solution is to choose the timesets accordingly to the skew or shift register rule. Data and clock have to run in different directions as long as enough timesets are available. It is more complicated if the data transition directions are not the same but have only one direction within the scan chain and also in the functional domain. In this case a chain reordering can solve the problem, i.e. the scan chain has to be coupled in such a way that the directions of domain transitions are equal. It is most complicated if within a domain there are transitions in both directions. Functional domain transitions in one of the directions will not be tested at all because timeset switching within a test is not possible.

Another problem is that even if in a test case the clocks are switching at the same time by means of test clock multiplexers, skew problems exist. The reason is that it is not possible to match the timing due to clock buffering and distribution. In addition process, temperature and power supply deviations as well as tester skew are cause additional problems.

To solve the problem of skew and data transition between different clock domains a methodology called latched scan design has been developed. It is shown in greater detail, e.g. in the German patent application DE 43 18 422 A1. The known methodology solves all problems for all kind of transitions and can be implemented for a design style which is based on edge-sensitive flip-flops combined with multiplexed scan methodology. The drawback of the known methodology however is that all flip-flops used in the IC need an additional latch which has to be added into the data path. This causes a twofold problem, on the one hand as an additional latch has to be added to all flip-flops a severe area overhead is caused, on the other hand as the latches have to be added into the data path additional delay is caused.

### SUMMARY OF THE INVENTION

Accordingly, it is an object of the present invention to provide a simple method for testing an integrated circuit with a minimum of area overhead being added to the integrated circuit for test purpose, causing only a minimum of delay being added to the data path.

The object is achieved by providing a method for achieving testability for circuitry having multiple clock systems, including a step of inserting multiplexed scan flip-flops into the circuitry, characterised by steps of analysing the circuitry to identify transitions between clock systems, and inserting additional storage elements into the circuitry at locations having transitions between the clock systems.

It is an other object of the present invention to provide an integrated circuit with a minimum of area overhead being added to the integrated circuit for test purpose, causing only a minimum delay to be added to the data path and using only a minimum of additional external pins.

The object is achieved by providing an integrated circuit with multiple clock systems having logic circuitry and a scan chain inserted for testability, characterised in, that additional storage elements are placed in the scan chain at locations having transitions between the clock systems.

An advantage of the present invention is that it allows an integrated circuit having a plurality of clock systems to be easily tested. Another advantage of the present invention is that it allows testability with a minimum of area overhead for test-circuitry to be achieved.

The present invention will become more fully understood from the detailed description given hereinafter and further scope of applicability of the present invention will become apparent. However, it should be understood that the detailed description is given by way of illustration only, since various changes and modifications within the spirit and scope of the invention will become apparent to those skilled in the art.

### BRIEF DESCRIPTION OF THE DRAWINGS

The following detailed description is accompanied by drawings of which
- Fig. 1: is a schematic diagram of a conventional multiplexed scan design having multiplexed scan flip-flops,
- Fig. 2: is a schematic diagram of a conventional multiplexed scan design having separate multiplexers and scan flip-flops,
- Fig. 3: is a schematic diagram of a first embodiment of an integrated circuit according to this invention having additional storage elements,
- Fig. 4: is a schematic diagram of a second embodiment of an integrated circuit according to this invention having additional storage elements,
- Fig. 5: is a schematic diagram of a third embodiment of an integrated circuit according to this invention having additional storage elements,
- Fig. 6: is a schematic diagram of two embodiments of the additional storage elements as shown in Fig. 3 to 5,
- Fig. 7: is a schematic diagram of first implementations of the additional storage element as shown in Fig. 6 a),
- Fig. 8: is a schematic diagram of second implementations of the additional storage element as shown in Fig. 6 b),
- Fig. 9: is a functional timing diagram for an integrated circuit according to this invention,
- Fig. 10: is a schematic diagram of a first example of a topology of the integrated circuit,
- Fig. 11: is a schematic diagram of a second example of a topology of the integrated circuit, and
- Fig. 12: is a flow chart of an optimisation algorithm for the inventive method.

Identical denotations in different Figures represent identical elements.

### DETAILED DESCRIPTION

Considering the sequential circuit in Fig. 2 there is a combinational or functional layer C and a storage layer SFx, SFy to form the functionality. For testing there is an extra layer added (test layer) which consists of scan multiplexers Mx, My controlled by a test enable signal via a test pin TE. The scan multiplexers Mx, My can be implemented together with the storage layer SFx, SFy and form the well known multiplexed scan flip-flops as shown in Fig. 1.

The circuit is first analysed to find where domain transitions occur. The scan chain SFx, SFy as well as the functional layer C is analysed for domain transitions by analysing, e. g. a net list of the circuit.

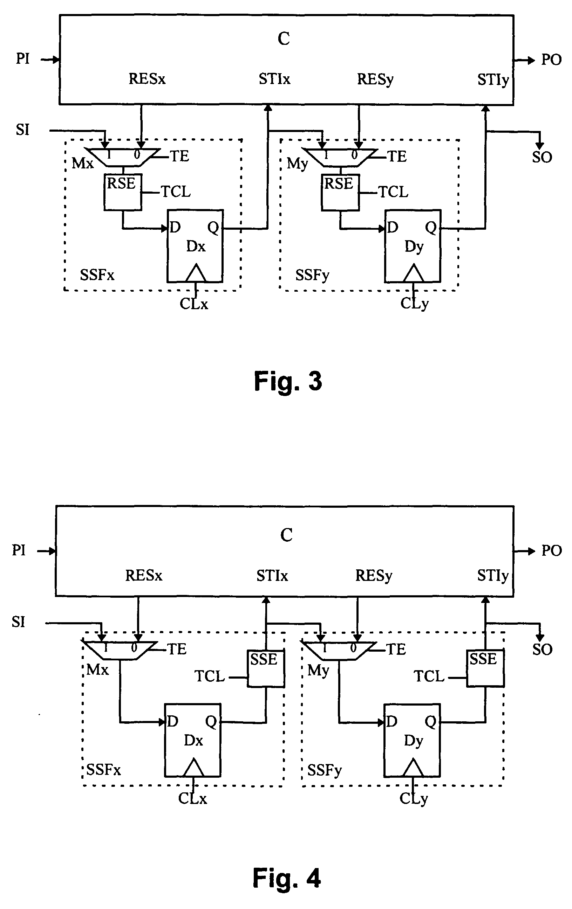

The test layer Mx, My is only changed at positions where transitions were found at the analysis of the circuit by adding additional storage elements for locking stimuli or responses in test mode, as shown in Fig. 3, 4 and 5. Additional storage elements SSE, RSE are controlled by a test clock signal via an extra test pin TCL By adding additional storage elements SSE, RSE the circuit is made stable, or test-synchronous, during shift and normal mode scan operation. The clocks CLx and CLy may be active at the same time without any skew problems.

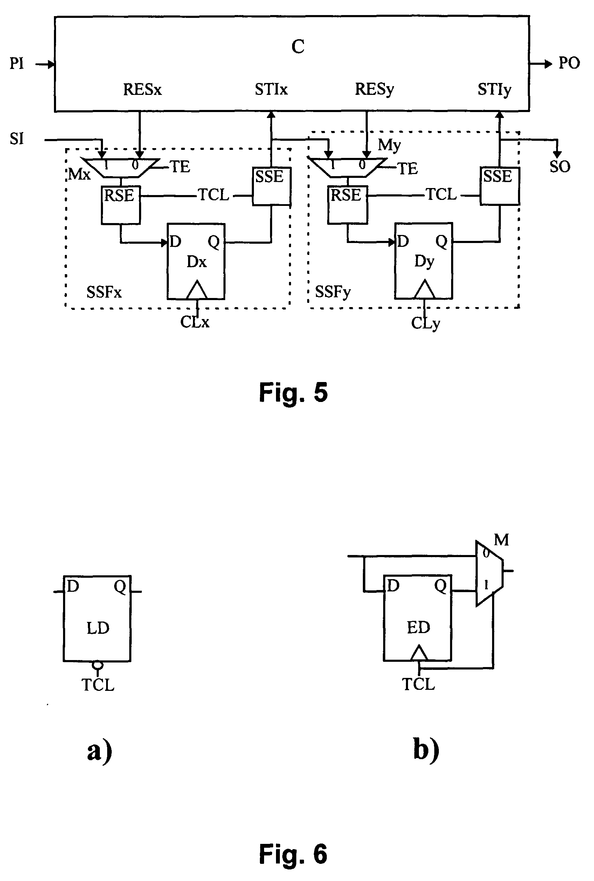

The additional storage elements SSE, RSE can be inserted either in the response path as response storage elements RSE and shown in Fig. 3, in the stimuli path as stimuli storage elements SSE and shown in Fig. 4 or as a mix of both additional storage elements SSE and RSE as shown in Fig. 5. Where to place additional storage elements SSE, RSE depends on the analysis of the circuit as explained above and an optimisation strategy which will be explained below. Between two flip-flops of a domain transition there must be added an additional storage element SSE or RSE to get a test-synchronous, skewless behaviour. It is also possible to use an appropriate extra timeset, which also will be explained below.

Following embodiments of the additional storage elements RSE, SSE will be explained. The additional storage elements RSE, SSE have to be transparent in functional mode and must behave as storage devices in test mode. The implementation is either a level sensitive latch LD as shown in Fig. 6 a) or an edge sensitive flip-flop ED combined with a multiplexer M as shown in Fig. 6 b). The level sensitive latch LD is triggered for test mode by the test clock signal via test pin TCL, its input D forms the input of the additional storage elements RSE, SSE its output Q forms the output of the additional storage elements RSE, SSE. If the additional storage elements RSE, SSE are formed by the combination of a edge sensitive flip-flop ED and a multiplexer M the flip-flop ED can be bypassed with the multiplexer M for functional operation. The test clock signal TCL triggers the flip-flop ED as well as the multiplexer M.

To integrate the additional storage elements RSE, SSE into the multiplexed scan flip-flops SSFx, SSFy as used and shown in Fig. 3, 4 and 5, two options are available.

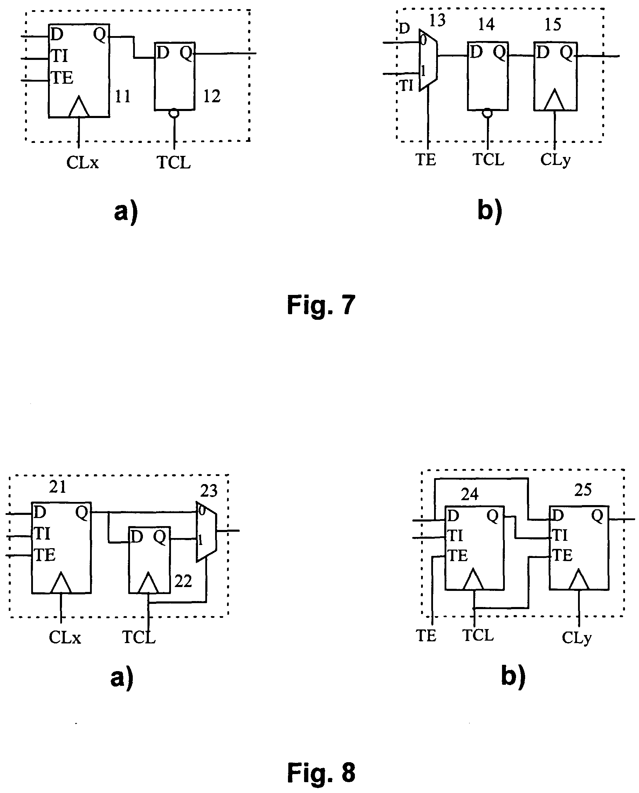

The latch based additional storage element SSE for stimuli storage (afterwards called type 1a) consists of a latch 12 following a normal scan flip-flop 11 as shown in Fig. 7a). The latch based additional storage element RSE for response storage (afterwards called type 1b) consists of a scan multiplexer 13 and a latch 14 followed by a D-flip-flop 15 as shown in Figure 7 b). These embodiments of type 1a and 1b are similar to the additional storage elements RSE and SSE based on the flip-flop multiplexer combination.

The flip-flop multiplexer based additional storage element SSE for stimuli storage (afterwards called type 2a) can be a combination of a multiplexed scan flip-flop 21 followed by a D-flip-flop 22 with a multiplexer 23 as shown in Fig. 8 a). The flip-flop multiplexer realisation of an additional storage element RSE for response storage (afterwards called type 2b) can be a combination of two multiplexed scan flip-flops 24 and 25 as shown in Fig. 8 b).

It should be noted that the multiplexed scan flip-flops SSFx, SSFy, formed as explained above for type 1 and 2, are built up with standard elements widely available. The main advantage of the latch based (type1) multiplexed scan flip-flops is a small area overhead. The disadvantage is the additional delay added to the functional path. Another disadvantage could arise from the fact that some ATPG tools are unable to deal with level sensitive elements. In case of type 2 multiplexed scan flip-flops there are no problems with added delay or ATPG tools. For type 2a multiplexer 23 is added to the data path whereas for type 2b flip-flop 24 is connected in parallel to the functional path which results in no extra delay. The disadvantage of type 2 is that the functional path across the multiplexer is not tested but this has low impact on fault coverage because of the relative small number of multiplexed scan flip-flops having additional storage elements needed in the circuitry.

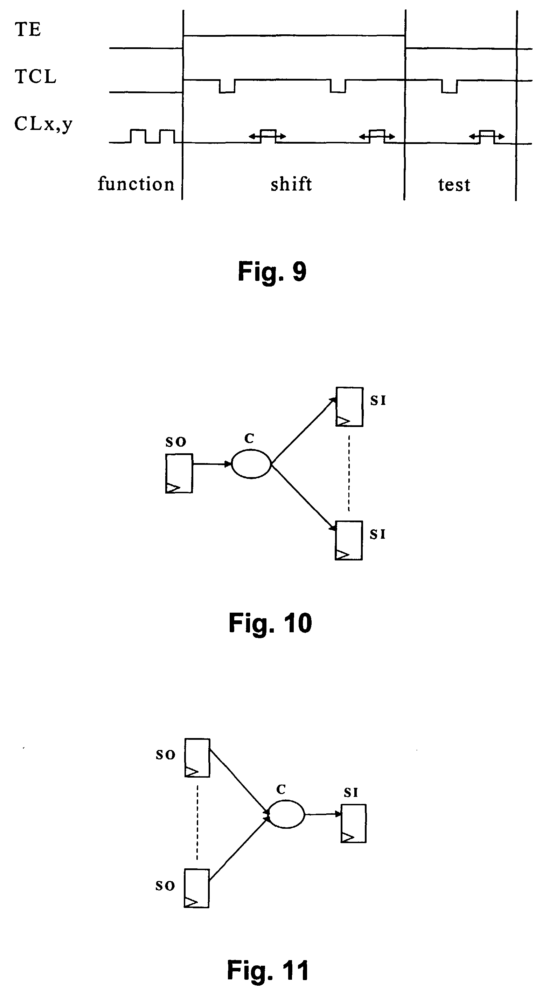

The simplicity of timing made available by the use of additional storage elements is shown in Fig. 9. In functional mode (test clock signal TCL=0 and test enable signal TE=0) the additional storage elements SSE, RSE are transparent and the multiplexed scan flip-flops SSFx, SSFy behave like conventional flips-flops. In scan shift mode (test enable signal TE=1) the scan chain formed by multiplexed scan flip-flops SSFx, SSFy is controlled by a skewless two phase clocking of the test clock signal TCL and clock signals CLx, CLy which are also applied in scan test mode (test enable signalTE=0). Because of the additional storage elements RSE, SSE the circuit is made test-synchronous, i. e. test stimuli and/or results are locked. The circuit therefore behaves like a two-phase level sensitive circuit for clock signals CLx, CLy. This allows any clock skew, if the timesets are large enough to allow the changes caused by test clock signal TCL to propagate through the combinational logic C of the circuit under test. The clock signals CLx, CLy must be controllable from external pins, as known from conventional scan test designs where test clock multiplexers are used for that purpose. Since clock signals CLx, CLy can be active at the same time without skew dependencies the clocks signals CLx, CLy may have the same signal source, for example the system clock. This means that no extra test clock pins are necessary, as is the case in conventional scan designs with internal clocks.

Following the implementation of the additional storage elements RSE, SSE and a method for optimisation will be explained.

The first step is an insertion of a scan chain as known from conventional scan test employing standard scan flip-flops SFx, SFy. Afterwards all flip-flops of the circuitry are replaced by multiplexed scan flip-flops SSFx, SSFy where required, i. e. as explained above where clock domain transitions occur. As explained above, two test signals are needed for multiplexed scan flip-flops SSFx, SSFy. The test enable signal TE for control of scan multiplexers Mx, My and the test clock signal TCL which controls the additional storage elements RSE, SSE to update and/or capture the scan data.

In order to be independent from vendors of ATPG tools and integrated circuit design tools the use of the following procedure may be of advantage.

Dual-phase flip-flops are inserted into the circuit to be tested where required, i.e. where necessary to form a scan chain as in conventional scan test. Dual-phase flip-flops are widely supported by vendors and scan insertion tools. The scan chains and the required test control lines are routed.
Analysis of the clock transitions whereat the clock transitions within scan chains are taken into account as well, e.g. as explained above by analysing a net list. Replacement of the dual-phase flip-flops by conventional multiplexed scan flip-flops SFx, SFy or multiplexed scan flip-flops having additional storage elements SSFx, SSFy. The decision which type of multiplexed scan flip-flop either SF or SSF is based upon the results of the clock transition analysis. The step of clock transition analysis will be explained below in greater detail, to show additional optimisation possibilities.

In a second step test patterns are generated. The above described insertion of additional storage elements allows a very simple circuitry model for ATPG, because skew problems between different test clocks are eliminated and the circuitry can be considered to be synchronous, when applying timesets to the test control signals.

Therefore very simple ATPG software suitable for synchronous or combinational circuitry can be used.

To further improve and optimise the insertion of additional storage elements towards lower area overhead, aspects in addition to the clock domain transitions have to be considered and will be described afterwards.

A first aspect is the structure of the circuitry. In Fig. 10 one source flip-flop SO feeds into several sink flip-flops SI. It is obvious that it is of advantage to equip the source flip-flop SO with one additional storage element SSE which stores the stimuli coming from the source flip-flop SO before entering into combinational logic C, instead of equipping each of the sink flip-flops SI with an additional storage element RSE which stores the results coming from the combinational logic C.

In Fig. 11 several source flip-flops SO feed via a combinational logic C into one sink flip-flop SI. In this case it is preferable to equip the sink flip-flop SI with an additional storage element RSE which stores the result.

The most effective way is to mix additional storage elements RSE and SSE, i.e. to insert stimuli storing elements SSE for schemes as shown in Fig. 10 and response storing elements RSE for schemes as shown in Fig. 11.

A second aspect for optimisation is the use of additional storage elements either being realised as type 1 or type 2 as explained above with regard to Fig. 7 and 8.

This aspect is mainly related to gate count (area overhead) and timing of the circuitry.
Gate count of additional storage elements of type1 is less than it is for type2, but type 1 has two disadvantages compared to type 2. Firstly, type 1 is inserted into the data path and therefore possibly adds a critical propagation delay to the data path. Second, some tools like static timing analyser or ATPG programs may not be able to handle latches correctly. Type 2 does not have these problems, but its gate overhead is higher and its use reduces fault coverage, since the wires to and from the original flip-flop are not tested as explained above.

A third aspect is the use of a single timeset for all test clocks versus operating with more than one timeset.

When detailed information about clock domain transitions is available, additional storage elements can be saved - and thus area overhead - by applying additional timesets in such a way that clock domain transitions do not cause a response capturing problem. One approach is to search for the clock system that has the most clock domain transition sinks or sources respectively and to clock that system first or last respectively during the test cycle. A more general approach is to analyse the circuitry concerning the clock domain transitions and define an order of test clocks that best suits the topology of the circuitry being analysed. The remaining clock domain transitions are handled as explained above by insertion of additional storage elements. It should be noted that for each additional timeset used an additional test pin for that timeset has to be used.

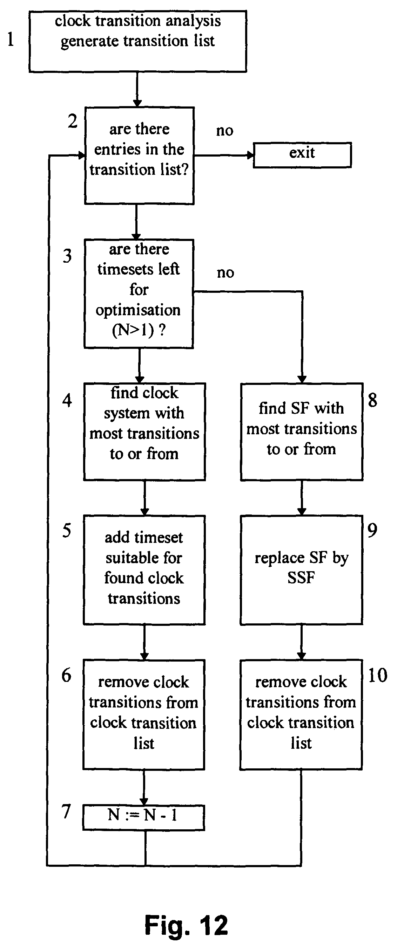

With regard to all the aspects mentioned above, an algorithm for optimisation could be applied as shown in Fig. 12. The counting variable N is the number of timesets to be used. If N is greater than one, additional timesets are used in order to save additional storage elements as explained above.

After a first step 1 of analysing the circuitry to be tested for clock domain transitions and generating a list of clock domain transitions it is checked at a second step 2 if any clock domain transitions occur. If there is no clock domain transition the algorithm ends. If there is any clock domain transitions it is checked at the next step 3 if additional timesets are to be used, i. e. if N is greater than one. If so, at step 4, the clock system with the most domain transitions to or from is identified. Followed by step 5, which adds a suitable timeset for the clock domain transitions as identified at step 4. At the next step 6 the clock domain transitions treated at step 5 are removed from the list of clock domain transitions as generated at step 1. At step 7 the counting variable N is decreased by one. The algorithm restarts at step 2 as explained above. If it is found at step 3 that no additional timeset is left for optimisation the algorithm is continued with step 8. At step 8 the multiplexed scan flip-flop (see Fig. 2, SFx, SFy) having the most clock domain transitions - either to or from - is identified. At step 9 the multiplexed scan flip-flop is replaced by a multiplexed scan flip-flop having one and/or two additional storage elements (see Fig. 3, 4 and 5, RSE and/or SSE). At step 10 the clock domain transitions treated at steps 8 and 9 are removed from the list of clock domain transitions as generated at step 1 and the algorithm is restarted at step 2.

## Claims

1. Method for achieving testability of an integrated circuit having multiple clock systems, including a step of
- inserting test circuitry into the integrated circuit,
**characterised by** the steps of
- analysing the integrated circuit to identify transitions between clock systems, and
- inserting additional storage elements into the integrated circuit at locations having said transitions between clock systems.

2. Method according to claim 1,
**characterised in,**
forming the test circuitry with multiplexed scan flip-flops.

3. Method according to claim 1 or 2,
**characterised by,**
placing the additional storage elements in front of the test circuitry.

4. Method according to claim 1 or 2,
**characterised by,**
placing the additional storage elements behind the test circuitry.

5. Method according to claim 1 or 2,
**characterised by,**
placing the additional storage elements in front of and behind the test circuitry.

6. Method according to a claim 1 to 5,
**characterised by,**
placing the additional storage elements in the integrated circuit at locations where a clock domain transition is branching out.

7. Method according to a claim 1 to 6,
**characterised by,**
placing the additional storage elements in the integrated circuit at locations where a plurality of clock domain transitions meet.

8. Integrated circuit with multiple clock systems having logic circuitry and a scan chain inserted for testability,
**characterised in that**
additional storage elements (RSE,SSE) are placed in the scan chain (SSFx,SSFy) at locations having transitions between the clock systems (CLx,CLy).
